# EUROPEAN PATENT SPECIFICATION

(11) **EP 2 106 895 B1**
(45) Date of publication and mention of the grant of the patent: **18.12.2013**
(21) Application number: 08254129.3
(22) Date of filing: 23.12.2008
(51) Int. Cl.: B29C 45/14, B29C 51/10, B29C 69/02

(54) **Case of electronic device and method for manufacturing the same**
Behälter für elektronisches Gerät und Verfahren zu dessen Herstellung
Boîte de dispositif électronique et son procédé de fabrication

(30) Priority: 02.04.2008 TW 97112028
(43) Date of publication of application: 07.10.2009
(73) Proprietor: Pegatron Corporation, Taipei City 112 (TW)
(72) Inventor: Chang, En-Bair, Tapei City 112 (TW); Ko, Cheng-Yu, Tapei City 112 (TW)
(74) Representative: Chamberlain, Alan James

(56) References cited:
- EP-A- 1 669 191
- EP-A- 1 688 248
- WO-A-02/24431
- JP-A- 1 028 998
- JP-A- 62 184 823
- JP-A- 2000 246 758
- US-A- 5 885 691

## Description

### Field of the Invention

The invention relates to a case and, more particularly, to a case of an electronic device and a method for manufacturing the same.

### Description of the Related Art

To prevent electromagnetic interference (EMI) and electrostatic discharge (ESD) from affecting stability of an electronic component of an electronic device during operating, a metal layer is generally coated on the internal surface of a plastic case body of the electronic device. Thereby, a case composed of the plastic case body and the metal layer can avoid the electromagnetic interface and the electrostatic discharge.

In the prior art, the plastic case body is first manufactured by an injection molding process. Then, a baked enamel coating process is performed on an external surface of the plastic case body to complete the decoration of the case. Afterwards, a piece of sheet metal with a shape in accordance with the shape of the internal surface of the plastic case body is assembled into the plastic case body. The metal layer also may be formed on the internal surface of the plastic case body by a sputtering process, an evaporation process, or an electroplating process, or metal foil such as aluminum foil or copper foil may be attached to the internal surface of the plastic case body as the metal layer of the case. In addition, conductive paint may be sprayed on the internal surface of the plastic case body to manufacture the metal layer of the case.

However, since the plastic case body needs to process the exterior of the case and the electromagnetic interface protection separately to proceed, the case are processed by many processing steps and long processing time. Thus, a defective rate of the products may increase, and the manufacturing cost may increase.

WO02/24431 discloses known multi-layered structures and methods for manufacturing multi-layered structures. JP2000246758 discloses a moulding made of resin and its manufacture. US5885691 discloses a known selectively reinforced thermoformed article and process.

### BRIEF SUMMARY OF THE INVENTION

The invention provides a method for manufacturing a case of an electronic device to simplify a manufacturing process of the case.

The invention provides a case of an electronic device to reduce manufacturing cost of the case.

The invention provides a method for manufacturing a case of an electronic device. The method includes the following steps. First, a vacuum formed film is formed on a first mold, and the vacuum formed film has a first surface and a second surface. Then, an electromagnetic shielding layer is formed on the first surface. Afterwards, a patterned film and the vacuum formed film are provided in a second mold, and an in-mold decoration injection molding process is performed to form a case body between the second surface and the patterned film.

According to an embodiment of the invention, the method of forming the electromagnetic shielding layer includes an electroplating process, an evaporation process, or a sputtering process.

According to an embodiment of the invention, the second mold has an upper mold, a lower mold, and a mold cavity formed between the upper mold and the lower mold.

According to an embodiment of the invention, the vacuum formed film and the case body are made of polyethylene terephthalate (PET).

According to an embodiment of the invention, the electromagnetic shielding layer is made of metal.

The invention further provides a case of an electronic device. The case has a vacuum formed film and an electromagnetic shielding layer. The vacuum formed film and the electromagnetic shielding layer are stacked in turn on a first surface of a case body at an inner side of the case, the electronic device further having a pattern disposed on the second surface of the case body at an outer side.

According to an embodiment of the invention, the vacuum formed film is made of polyethylene terephthalate.

According to an embodiment of the invention, the electromagnetic shielding layer is made of metal.

In the method for manufacturing the case of the electronic device of the invention, external surfaces of the case of the electronic device and the electromagnetic shielding layer are manufactured together in the in-mold decoration injection molding process. Thus, manufacture and processing procedures of the case of the electronic device are greatly simplified to shorten the manufacturing time and reduce the manufacturing cost.

These and other features, aspects, and advantages of the present invention will become better understood with regard to the following description, appended claims, and accompanying drawings.

### BRIEF DESCRIPTION OF THE DRAWINGS

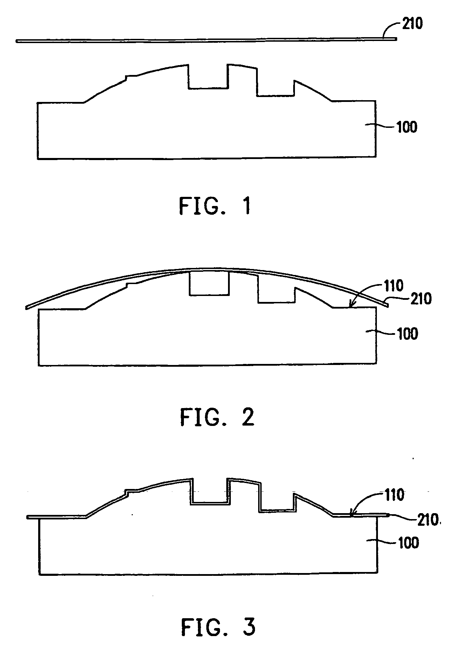

FIG. 1 to FIG. 9 are sectional schematic diagrams showing flow paths of a method for manufacturing a case of an electronic device according to an embodiment of the invention.

### DETAILED DESCRIPTION OF THE EMBODIMENTS

FIG. 1 to FIG. 9 are sectional schematic diagrams showing flow paths of a method for manufacturing a case of an electronic device according to an embodiment of the invention. As shown in FIG. 1, first, a first mold 100 and a plastic film 210 are provided. The plastic film 210 is made of, for example, polyethylene terephthalate (PET). Then, as shown in FIG. 2, the plastic film 210 is approximately attached to a surface 110 of the first mold 100. Afterwards, the plastic film 210 is made to form a vacuum formed film 210a in a vacuum forming process. In detail, the method of forming the vacuum formed film 210a is, for example, to perform a vacuum process first to extract air between the first mold 100 and the plastic film 210. Thus, as shown in FIG. 3, the plastic film 210 is totally attached to the surface 110 of the first mold 100.

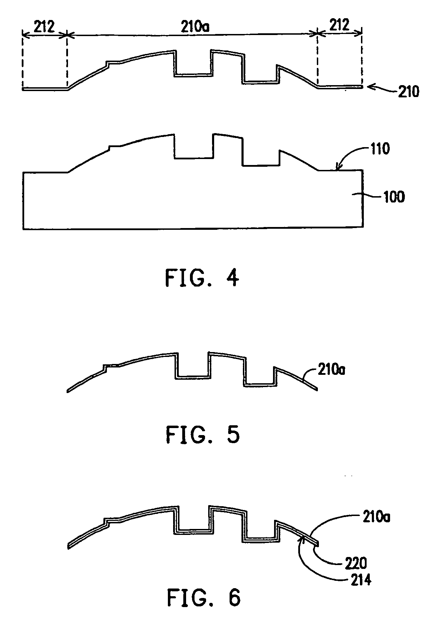

Afterwards, after the plastic film 210 is taken out from the first mold 100 (as shown in FIG. 4), and waste 212 of the plastic film 210 are cut, the vacuum formed film 210a is formed, as shown in FIG. 5. Then, as shown in FIG. 6, an electromagnetic shielding layer 220 is formed on a first surface 214 of the vacuum formed film 210a via an electroplating process, an evaporation process, or a sputtering process. The electromagnetic shielding layer 220 is made of, for example, metal.

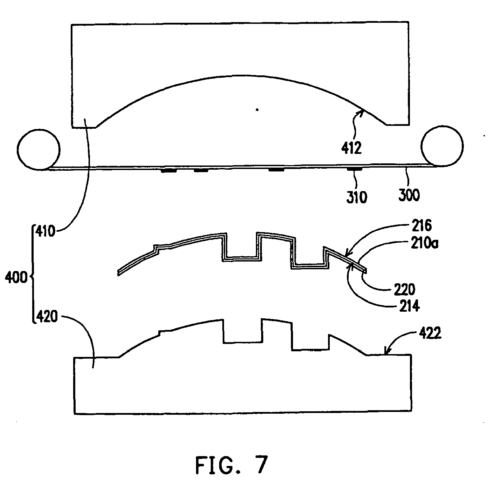

Afterwards, as shown in FIG. 7, a patterned film 300 and a second mold 400 are provided. The patterned film 300 has a pattern 310 (a plurality of patterns are shown), and the second mold 400 has an upper mold 410 and a lower mold 420. The shape of a surface 422 of the lower mold 420 is, for example, corresponding to the shape of the vacuum formed film 210a. Then, the patterned film 300 is disposed between the upper mold 410 and the lower mold 420, and the vacuum formed film 210a is disposed between the patterned film 300 and the lower mold 420. At that moment, the electromagnetic shielding layer 220 is located toward the lower mold 420, and a second surface 216 opposite to the first surface 214 of the vacuum formed film 210a is located toward the upper mold 410.

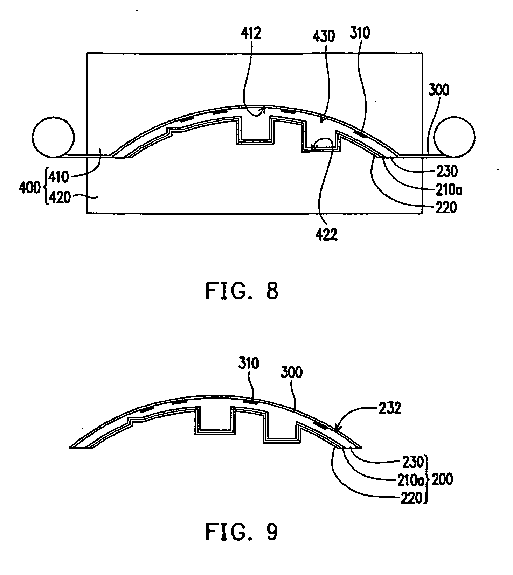

Afterwards, as shown in FIG. 8, the upper mold 410 and the lower mold 420 are combined to form a mold cavity 430. At that moment, the vacuum formed film 210a and the pattern 310 of the patterned film 300 are both located in the mold cavity 430, and the vacuum formed film 210a is against the lower mold 420. Then, an in-mold decoration injection molding process is performed to continuously inject a material between the second surface 216 of the patterned film 300 and the vacuum formed film 210a until the patterned film 300 is smoothly attached to a surface 412 of the upper mold 410. The material is, for example, polyethylene terephthalate or another plastic material.

Afterwards, a solidifying process is performed to solidify the material and form a case body 230 integrated with the vacuum formed film 210a between the patterned film 300 and the second surface 216 of the vacuum formed film 210a. Then, as shown in FIG. 9, after the second mold 400 and the patterned film 300 are removed, a case 200 of an electronic device is formed. The vacuum formed film 210a and the electromagnetic shielding layer 220 are stacked on the internal surface of the case 200 of the electronic device in turn.

After the solidifying process is performed, the pattern 310 of the patterned film 300 may be printed on a surface 232 of the case body 230 with the solidification of the material (as shown in FIG. 9). Therefore, in the invention, when the in-mold decoration injection molding process is performed, the external surfaces may be manufactured together with the electromagnetic shielding layer to simplify the process.

To sum up, in the method for manufacturing the case of the electronic device of the invention, when the in-mold decoration injection molding process is performed, the external surfaces of the case of the electronic device are manufactured together with the electromagnetic shielding layer. Thus, manufacture and processing procedures of the case of the electronic device are greatly simplified to shorten the manufacturing time and reduce the manufacturing cost.

Although the present invention has been described in considerable detail with reference to certain preferred embodiments thereof, the disclosure is not for limiting the scope of the invention. Persons having ordinary skill in the art may make various modifications and changes without departing from the scope of the invention. Therefore, the scope of the appended claims should not be limited to the description of the preferred embodiments described above.

## Claims

1. A method for manufacturing a case (200) of an electronic device, comprising the steps of:
forming a vacuum formed film (210a) on a first mold (100), wherein the vacuum formed film (210a) has a first surface and a second surface;
forming an electromagnetic shielding layer (220) on the first surface; and
providing a patterned film (300) and the vacuum formed film (210a) in a second mold (400), and performing an in-mold decoration injection molding process to form a case body between the second surface and the patterned film (300).

2. A method for manufacturing the case (200) of the electronic device according to claim 1, wherein the way of forming the electromagnetic shielding layer (220) comprises an electroplating process, an evaporation process, or a sputtering process.

3. A method for manufacturing the case (200) of the electronic device according to claim 1, wherein the second mold (400) has an upper mold (410), a lower mold (420), and a mold cavity (430) formed between the upper mold (410) and the lower mold (420).

4. A method for manufacturing the case (200) of the electronic device according to claim 1, wherein the vacuum formed film (210a) and the case body (230) are made of polyethylene terephthalate (PET).

5. A method for manufacturing the case (200) of the electronic device according to claim 1, wherein the electromagnetic shielding layer (220) is made of metal.

6. A case (200) of an electronic device, **characterized in that** the case includes a case body (230), a vacuum formed film (210a) and an electromagnetic shielding layer (220), wherein the vacuum formed film (210a) and the electromagnetic shielding layer (220) are stacked in turn on a first surface of the case body (230) at an inner side of the case (200), the electronic device further comprising a pattern (310) disposed on a second surface (232) of the case body (230) at an outer side.

7. A case (200) of the electronic device according to claim 6, wherein the vacuum formed film (210a) is made of polyethylene terephthalate.

8. A case (200) of the electronic device according to claim 6, wherein the electromagnetic shielding layer (220) is made of metal.

## Patentansprüche

1. Verfahren zur Herstellung eines Gehäuses (200) einer elektronischen Vorrichtung, umfassend die Schritte:
Bilden eines vakuumgeformten Films (210a) auf einer ersten Form (100), wobei der vakuumgeformte Film (210a) eine erste Oberfläche und eine zweite Oberfläche aufweist;
Bilden einer elektromagnetischen Abschirmschicht (220) auf der ersten Oberfläche; und
Bereitstellen eines gemusterten Films (300) und des vakuumgeformten Films (210a) in einer zweiten Form (400) und Durchführen eines In-Mold-Ausgestaltungs-Spritzgieß-Prozesses, um einen Gehäusekörper zwischen der zweiten Oberfläche und dem gemusterten Film (300) zu bilden.

2. Verfahren zur Herstellung eines Gehäuses (200) einer elektronischen Vorrichtung gemäß Anspruch 1, wobei die Art des Bildens der elektromagnetischen Abschirmschicht (220) einen Galvanisierungsprozess, eine Aufdampfungsprozess, oder einen Sputterprozess umfasst.

3. Verfahren zur Herstellung eines Gehäuses (200) einer elektronischen Vorrichtung gemäß Anspruch 1, wobei die zweite Form (400) eine obere Form (410), eine untere Form (420) und einen Formhohlraum (430), die zwischen der oberen Form (410) und er unteren Form (420) gebildet ist, aufweist.

4. Verfahren zur Herstellung eines Gehäuses (200) einer elektronischen Vorrichtung gemäß Anspruch 1, wobei der vakuumgeformte Film (210a) und der Gehäusekörper (230) aus Polyethylenterephthalat (PET) gebildet sind.

5. Verfahren zur Herstellung eines Gehäuses (200) einer elektronischen Vorrichtung gemäß Anspruch 1, wobei die elektromagnetische Abschirmschicht (220) aus Metall gefertigt ist.

6. Gehäuse (200) einer elektronischen Vorrichtung, **dadurch gekennzeichnet, dass** das Gehäuse einen Gehäusekörper (230), einen vakuumgeformten Film (210a) und eine elektromagnetische Abschirmschicht (220) enthält, wobei der vakuumgeformte Film (210a) und die elektromagnetische Abschirmschicht (220) nacheinander auf einer ersten Oberfläche des Gehäusekörpers (230) an einer Innenseite des Gehäuses (200) aufgeschichtet sind, wobei die elektronische Vorrichtung weiterhin ein Muster (310) umfasst, das auf einer zweiten Oberfläche (232) des Gehäusekörpers (230) an einer Außenseite angeordnet ist.

7. Gehäuse (200) einer elektronischen Vorrichtung gemäß Anspruch 6, wobei der vakuumgeformte Film (210a) aus Polyethylenterephthalat gebildet ist.

8. Gehäuse (200) einer elektronischen Vorrichtung gemäß Anspruch 6, wobei die elektromagnetische Abschirmschicht (220) aus Metall gefertigt ist.

## Revendications

1. Procédé de fabrication d'un boîtier (200) d'un dispositif électronique, comprenant les étapes consistant à :
former un film (210a) façonné sous vide, sur un premier moule (100), ledit film (210a) façonné sous vide comprenant une première surface et une seconde surface ;
former une couche (220) de blindage électromagnétique sur la première surface ; et
fournir un film (300) à profilage et le film (210a) façonné sous vide, dans un second moule (400), et exécuter un processus de moulage décoratif par injection dans ledit moule, pour former un corps de boîtier entre la seconde surface et ledit film (300) à profilage.

2. Procédé de fabrication du boîtier (200) du dispositif électronique, selon la revendication 1, dans lequel le mode de formation de la couche (220) de blindage électromagnétique comprend un processus de galvanoplastie, un processus de vaporisation ou un processus de pulvérisation cathodique.

3. Procédé de fabrication du boîtier (200) du dispositif électronique, selon la revendication 1, dans lequel le second moule (400) comprend un moule supérieur (410), un moule inférieur (420) et une cavité de moulage (430) formée entre ledit moule supérieur (410) et ledit moule inférieur (420).

4. Procédé de fabrication du boîtier (200) du dispositif électronique, selon la revendication 1, dans lequel le film (210a) façonné sous vide, et le corps (230) dudit boîtier, sont constitués de polytéréphtalate d'éthylène (PET).

5. Procédé de fabrication du boîtier (200) du dispositif électronique, selon la revendication 1, dans lequel la couche (220) de blindage électromagnétique consiste en du métal.

6. Boîtier (200) d'un dispositif électronique, **caractérisé par le fait que** ledit boîtier comprend un corps (230), un film (210a) façonné sous vide et une couche (220) de blindage électromagnétique, ledit film (210a) façonné sous vide et ladite couche (220) de blindage électromagnétique étant empilés tour à tour sur une première surface dudit corps (230) du boîtier, sur une face intérieure dudit boîtier (200), le dispositif électronique comprenant, en outre, un profilage (310) situé sur une seconde surface (232) dudit corps (230) du boîtier, sur une face extérieure.

7. Boîtier (200) du dispositif électronique, selon la revendication 6, dans lequel le film (210a) façonné sous vide est constitué de polytéréphtalate d'éthylène.

8. Boîtier (200) du dispositif électronique, selon la revendication 6, dans lequel la couche (220) de blindage électromagnétique consiste en du métal.
